# EUROPÄISCHE PATENTSCHRIFT

(11) **EP 4 167 699 B1**
(45) Veröffentlichungstag und Bekanntmachung des Hinweises auf die Patenterteilung: **11.11.2026**
(21) Anmeldenummer: 22199175.5
(22) Anmeldetag: 30.09.2022
(51) Int. Cl.: H05K 7/20

(54) **ELEKTRONISCHES GERÄT MIT AKTIVER KÜHLUNG**
ELECTRONIC DEVICE WITH ACTIVE COOLING
DISPOSITIF ÉLECTRONIQUE À REFROIDISSEMENT ACTIF

(30) Priorität: 14.10.2021 DE 102021211599
(43) Veröffentlichungstag der Anmeldung: 19.04.2023
(73) Patentinhaber: AUMOVIO Germany GmbH, 60488 Frankfurt am Main (DE)
(72) Erfinder: Hildebrand, Bernd, 60488 Frankfurt am Main (DE); Nehm, Georg, 60488 Frankfurt am Main (DE)
(74) Vertreter: Aumovio Corporation

(56) Entgegenhaltungen:
- DE-A1- 102018 208 698
- US-A1- 2021 216 119
- US-A1- 2021 265 718

## Beschreibung

Die vorliegende Erfindung betrifft ein elektronisches Gerät mit einem Gehäuse und zumindest einem zu kühlenden elektronischen Bauteil, das auf einer Geräteleiterplatte im Inneren des Gehäuses angeordnet ist. Zumindest eines der elektronischen Bauteile wird zur Realisierung der Funktionalität des elektronischen Geräts genutzt.

Zur Abfuhr von durch Verlustleistung an elektronischen Komponenten bzw. elektronischen Bauteilen entstandener Wärme sind aus dem Stand der Technik aktive Konvektionslösungen mit erzwungener Luftbewegung mittels Lüfter bekannt. Bei den aus dem Stand der Technik bekannten Lösungen werden Lüfter in der Regel als komplette Baugruppe also zusammen mit Lüftergehäuse, Kabel und Stecker innerhalb von bzw. von außen an Gerätegehäusen verbaut.

Befindet sich der Lüfter innerhalb des Gehäuses, wird die Luftströmung durch das Gerät geführt und die Entwärmung der Bauteile findet direkt über den Luftstrom statt. Dabei können mit der Luftströmung Staub, Schmutz, feuchte Luft und/oder Flüssigkeiten in das Innere des Gerätes gelangen. Diese können die elektronischen Komponenten kontaminieren, was wiederum zu Fehlfunktionen wie z.B. infolge Elektromigration führen kann.

Wird der Lüfter von außen an das Gerät befestigt, so findet die Luftströmung außerhalb des Geräts statt, wobei üblicherweise die Wärmeableitung der zu entwärmenden Komponenten über eine thermische Kopplung mittels eines thermisch leitfähigen Materials an ein Gehäuse stattfindet und die Wärmeableitung an die Umgebungsluft über außenliegende Kühlrippen erfolgt. Hierbei besteht eine Problematik darin, dass ein mechanischer Schutz gegen Berührung eines Lüfterrotors als zusätzliche Komponente benötigt wird. Weiterhin erfolgt die elektrische Kontaktierung mittels einer Kabelverbindung und Stecker üblicherweise über einen aufwändigen manuellen Kabelverlege- und Kontaktierungs-Prozess.

Dies bedeutet einen Mehraufwand an Bauteilen mit verbundenen Teile-Mehrkosten und einen Mehraufwand an Montageschritten mit verbundenen Mehrkosten für die Montage. Zusätzlich beanspruchen die Komponenten Lüftergehäuse und der elektrische Anschluss über Kabel und Stecker zusätzlich Bauraum, der die Nutzung des zur Verfügung stehenden Gerätebauraums einengt.

Ein Lüfter weist üblicherweise einen beweglichen rotierenden Teil, den Lüfterrotor, und einen festen Teil, den Stator auf. Zum Betrieb des Lüfters wird zumindest ein Stromanschluss für den Stator benötigt. Dafür sind zwei Leitungen vorgesehen, ein Masse- und ein Spannungsanschluss. Darüber hinaus werden bei modernen Lüftern immer auch eine dritte Leitung für eine Drehzahl Sensorik, und somit zum Bestimmen der Drehzahl des Lüfters verwendet. Zusätzlich weisen PWM-Lüfter (PWM: Pulsweitenmodulation), die vor allem für die Kühlung einer CPU vorgesehen sind, noch eine vierte Leitung auf. Diese vierte Leitung wird für die Elektronik der Drehzahlsteuerung genutzt. Lüfterelektronik und Lüfter Sensorik sind dabei typischerweise auf einer Lüfterleiterplatte verbaut, die den Bauraum des Lüfters limitieren.

Aus der DE 10 2018 208 698 A1 ist eine wasserdichte elektronische Vorrichtung mit einem auf dem Gehäuse der Vorrichtung aufsitzenden Lüfter mit Lüftergehäuse bekannt. Die US 2021/265718 A1 beschreibt ein elektronisches Gerät gemäß Oberbegriff des unabhängigen Anspruchs 1.

Um zu verhindern, dass bei innerhalb eines Gehäuses verbauten Lüftern mit der Luftströmung Staub, Schmutz, feuchte Luft und/oder Flüssigkeiten in das Innere des Gerätes gelangen und somit elektronische Bauteile schädigen können, sind aus dem Stand der Technik bereits Lösungen bekannt, bei denen aufwendig eigens angelegte Luftstromführungen durch das Gehäuse gelegt werden. Ferner sind Lösungen bekannt bei denen die angesaugte Luft gefiltert wird, bevor sie in das Innere des Gehäuses gelangt. All dies bedeutet jedoch einen Mehraufwand an Bauteilen und zusätzliche Montageschritte mit jeweils verbundenen Mehrkosten.

Zudem ist es nicht nur wichtig elektronische Bauteile innerhalb des Gehäuses vor dem Eindringen von Staub, Schmutz, feuchter Luft und/oder Flüssigkeiten zu schützen, sondern ebenso vor dem Eindringen von elektromagnetischer Strahlung. Dies ist als EMV-Schutz (EMV: elektromagnetische Verträglichkeit) bekannt.

Beispielsweise ist die DE 10 2018 120 053 A1 bekannt. Sie beschreibt ein elektronisches Gerät mit einem Axiallüfter und einem Gehäuse, das einen Kühlkörper mit Kühlrippen aufweist. Der Axiallüfter ist in einem Aufnahmeraum des Gehäuses untergebracht, der beidseitige Öffnungen aufweist, so dass Luft auf der einen Seite angesaugt und zur anderen, gegenüberliegenden Seite ausgegeben wird. Die Kühlrippen sind beabstandet zu dem Aufnahmeraum, der den Lüfter umschließt, auf der Seite angeordnet, an der Luft von dem Axiallüfter ausgegeben wird. Der Axiallüfter wird dabei als gesamte Baugruppe, also samt Lüftergehäuse in dem Aufnahmeraum untergebracht. Das Lüftergehäuse soll dafür sorgen, dass eine Öffnung in das Innere des Gehäuses, die im Aufnahmeraum vorhanden ist, weitestgehend verschlossen wird. So soll verhindert werden, dass Staub, Schmutz, feuchte Luft und/oder eine Flüssigkeit in das Innere des elektronischen Gerätes und somit an elektronische Bauteile gelangen kann. Aus der DE 10 2018 120 053 A1 geht jedoch auch hervor, dass eine vollständige Abdichtung des Aufnahmeraumes zu dem Inneren des Gehäuses nur dann möglich ist, wenn um das Lüftergehäuse noch zusätzlich ein hin zu der Innenkontur des Aufnahmeraumes abdichtender Rahmen, Dichtelement oder dergleichen angeordnet wird. Es ist somit nachteilig, dass um das Innere vor einem Eindringen von Staub, Schmutz, feuchter Luft und/oder einer Flüssigkeit zu bewahren aufgrund des notwendigen Lüftergehäuses ein erhöhter Platzbedarf für den Lüfter geschaffen werden muss. Zudem muss ein zusätzliches Dichtelement verwendet werden, um auch wirklich zu gewährleisten, dass selbst mit Lüftergehäuse kein Staub, Schmutz, feuchte Luft und/oder eine Flüssigkeit in das Innere des elektronischen Gerätes gelangen kann. Je nach Beschaffenheit des Lüftergehäuses, das typischerweise aus Kunststoff besteht, und des Dichtelelements kann zudem elektromagnetische Strahlung, die durch die beidseitigen Öffnungen in den Aufnahmeraum eindringt, auch in das Innere des Gehäuses eindringen. Ein ausreichender EMV-Schutz ist dann nicht mehr gewährleistet.

Aufgabe der vorliegenden Erfindung ist es daher ein elektronisches Gerät mit aktiver Kühlung bereitzustellen, das zumindest einen der zuvor genannten Nachteile überwindet. Insbesondere ist es Aufgabe der vorliegenden Erfindung ein elektronisches Gerät mit aktiver Kühlung bereitzustellen, das eine kompakte Bauweise ermöglicht und zudem ein hohes Maß an ESD/EMV-Schutz (ESD: Electro-Static-Discharge) und ein hohes Maß an IP-Schutz (IP: Ingress Protection), also einen Schutz vor einem Eindringen von Staub, Schmutz, feuchter Luft, Flüssigkeiten und/oder vor Berührungen, gewährleistet.

Zumindest eine dieser Aufgaben wird durch ein elektronisches Gerät nach dem unabhängigen Anspruch gelöst. Bevorzugte Ausgestaltungen der Erfindung sind Gegenstand der abhängigen Ansprüche.

Gemäß der vorliegenden Erfindung ist das Gehäuse des elektronischen Gerätes mit einem Grundkörper eines Lüfters verbunden. Der Lüfter weist dabei kein zusätzliches eigenes Lüftergehäuse, wie etwa ein Kunststoffgehäuse, auf. Der Lüfter weist somit ebenfalls kein von dem Lüfter ausgebildetes Gehäuseteil auf, welches die Lüfterblätter des Lüfterrotors irgendwie bereichsweise umschließt. Der Grundkörper ist somit nicht mit einem zu dem Lüfter gehörenden eigenen Lüftergehäuse zu verwechseln. Vorzugsweise weist der Grundkörper eine plattenförmige Ausgestaltung auf. Besonders bevorzugt besteht der Grundkörper aus einem oder mehreren Kunststoffen. In einem verbundenen Zustand von Grundkörper und Gehäuse wird eine Öffnung zum Inneren des Gehäuses verschlossen. In dem verbundenen Zustand von Grundkörper und Gehäuse wird zudem eine Kammer in dem Gehäuse ausgebildet, die von dem Inneren des Gehäuses getrennt ist. Ferner ist der Grundkörper mit einer Buchse verbunden, auf der der Lüfterrotor des Lüfters rotierend gelagert ist. Die Buchse bildet dabei eine Erhebung, die von dem Grundkörper absteht. Um zu einer kompakten Bauweise beizutragen sind bevorzugterweise der Grundkörper und das Gehäuse derart miteinander verbunden und zueinander angeordnet, dass die Rotationsachse des Lüfterrotors in einer Richtung senkrecht zur Erstreckungsrichtung eines Bereichs des Gehäuses verläuft mit dem der Grundkörper verbunden und an dem ein Kühlkörper angeordnet ist. Eine Verbindung von Grundkörper und Gehäuse erfolgt dabei bei einer Montage von einer Innenseite des Gehäuses, also durch einen Bereich, in dem die Geräteleiterplatte angeordnet wird. Bei einer Montage wird daher in einem Schritt zunächst eine Verbindung zwischen Grundkörper und Gehäuse hergestellt, so dass die Kammer ausgebildet und in dieser der Lüfterrotor angeordnet wird. In einem nachfolgenden Schritt erfolgt dann eine Anordnung der Geräteleiterplatte in einem Bereich des elektronischen Gerätes, der das Innere des Gehäuses bildet. Durch die Ausgestaltung der Kammer und die vorgegebene Montagerichtung, kann diese insgesamt klein gehalten und dadurch das elektronische Gerät sehr kompakt ausgestaltet werden. In dem verbundenen Zustand von Grundkörper und Gehäuse ist der Lüfterrotor innerhalb der Kammer angeordnet. Die Kammer bzw. das Gehäuse des elektronischen Geräts ist so ausgebildet, dass es in einem verbundenen Zustand mit dem Grundkörper ein Gehäuse für den Lüfterrotor ausbildet. Dadurch entfällt, wie bereits oben erläutert ein eigenständiges Lüftergehäuse und es kann eine freie Gestaltung von Lufteinlass und Luftauslass erfolgen. Lufteinlass und Luftauslass werden über die Gehäusegeometrie des elektronischen Gerätes in der Kammer ausgebildet wodurch eine Luftströmung gezielt über die Gehäusegeometrie geleitet werden kann. Hierdurch können beispielsweise Strömungsgeräusche des Lüfters reduziert werden. Dadurch, dass die Kammer von dem Inneren des Gehäuses getrennt ist, findet zudem eine räumliche Trennung von dem Inneren des Gehäuses und dem Bereich statt, in dem der Lüfterrotor angeordnet wird. Hierdurch können Geräteleiterplatten und elektronische Bauteile im Inneren des Gehäuses effektiv und einfach vor einem Eindringen von Staub, Schmutz, feuchter Luft und Flüssigkeiten, sowie vor einem Eindringen von elektromagnetischer Strahlung geschützt werden. Durch die Ausgestaltung der Kammer, und dadurch, dass auf ein eigenes Lüftergehäuse verzichtet wird, lässt sich insgesamt eine kompakte Ausgestaltung eines elektronischen Gerätes erzielen. Zudem ist die Kammer insgesamt so ausgebildet, dass sie als Bereich für die Führung und Generierung der Luftströmung durch den Lüfter dient, dabei von in dem Inneren des Gerätes befindlichen elektronischen Bauteilen abgekapselt ist und als Abdeckung gegen mechanischen Zugriff schützt.

Die Buchse ist so ausgestaltet, dass der Lüfterrotor rotierend an der Buchse gelagert ist. Die Buchse kann dabei als Lager ausgestaltet sein oder ein solches aufweisen, so dass der Lüfterrotor rotierend an der Buchse lagerbar ist. In einer Ausführungsform der vorliegenden Erfindung erfolgt eine Verbindung von Buchse und Grundkörper über ein Befestigungsmittel. Beispielsweise können als Befestigungsmittel Adhäsions- und/oder Schraub- und/oder Niet- und/oder Klemm- und/oder Rastmittel genutzt werden. Eine solche Ausführungsform, in der Buchse und Grundkörper zweistückig ausgestaltet und durch ein Befestigungsmittel verbunden werden muss, hat den Vorteil, dass die Buchse standardisiert und der Grundkörper gerätespezifisch ausgeführt werden kann. Dadurch können Herstellungskosten reduziert werden. In einer bevorzugten Ausführungsform der vorliegenden Erfindung sind Buchse und Grundkörper einstückig ausgestaltet. Eine einstückige Ausgestaltung trägt zu einer Vereinfachung und Verbesserung eines Erreichens eines ESD/EMV-Schutzes und eines Schutzes vor einem Eindringen von Schmutz, Staub und/oder Ähnlichem bei. Eine einstückige Ausgestaltung verringert zudem Montageschritte bei einem Zusammenbau des Lüfters bzw. des elektronischen Gerätes.

In einer bevorzugten Ausführungsform der vorliegenden Erfindung besteht der Grundkörper aus einem elektrisch leitenden Material bzw. Werkstoff. Der Grundkörper kann beispielsweise aus einem Metall, etwa einem Metallblech, bestehen. Bevorzugterweise besteht der Grundkörper aus einem elektrisch leitenden Kunststoff. Die Verwendung eines elektrisch leitenden Materials wirkt sich zusätzlich vorteilhaft auf einen EMV-Schutz aus. Ferner kann ein Grundkörper, der aus einem Kunststoff mit elektrisch leitenden Eigenschaften besteht, zusätzlich auch wärmeleitende Eigenschaften aufweisen. Hierdurch kann eine Abfuhr von Wärme zusätzlich begünstigt werden.

In einer Ausführungsform der vorliegenden Erfindung gehen Grundkörper und Gehäuse eine direkte Verbindung ein. Eine direkte Verbindung von Grundkörper und Gehäuse erfolgt beispielsweise über ein Befestigungsmittel, das Grundkörper und Gehäuse direkt miteinander verbindet. Beispielsweise können als Befestigungsmittel Adhäsions- und/oder Schraub- und/oder Niet- und/oder Klemm- und/oder Rastmittel genutzt werden. Es versteht sich, dass in dieser Ausführungsform eine Öffnung zum Inneren des Gehäuses durch den Grundkörper verschlossen wird.

In einer besonders bevorzugten Ausführungsform weisen der Grundkörper und das Gehäuse eine elektrisch leitende Verbindung auf. Die Verbindung zwischen Grundkörper und Gehäuse kann beispielsweise über eine Verschraubung, Klemmung, Vernietung, Verklipsung, Verstemmung, Verrastung, Schweißung oder ähnliches erfolgen. Insbesondere bei einer Ausführungsform, in der der Grundkörper aus einem elektrisch leitenden Material besteht und somit ein weitgehend umlaufender elektrischer Kontakt zwischen Grundkörper und Gehäuse hergestellt wird, kann sich eine elektrisch leitende Verbindung zwischen Grundkörper und Gehäuse vorteilhaft auf einen ESD-/EMV-Schutz auswirken.

In einer besonders bevorzugten Ausführungsform der vorliegenden Erfindung weisen der Grundkörper und das Gehäuse eine elektrisch leitende Klebeverbindung auf. Vorzugsweise weist die elektrisch leitende Klebeverbindung zusätzlich akustisch dämpfende Eigenschaften auf. Beispielsweise kann die elektrisch leitende Klebeverbindung elektrisch leitfähig ausgebildet sein und eine elastomerische Konsistenz aufweisen. Die Klebeverbindung kann dann zusätzlich für eine akustische Entkoppelung des Lüfters zum Gehäuse sorgen und/oder zu dieser beitragen.

In einer Ausführungsform der vorliegenden Erfindung besteht der Grundkörper aus einem Spritzguss Bauteil. In einer bevorzugten Ausführungsform der vorliegenden Erfindung besteht der Grundkörper aus einem Mehrkomponenten-Spritzguss Bauteil. Vorzugsweise besteht der Grundkörper aus einem Kunststoffbauteil, hergestellt in einem Mehrkomponenten-Spritzgussverfahren. Eine Ausführungsform eines Mehrkomponenten-Spritzgussbauteils bietet eine einfache Möglichkeit einen Grundkörper mit unterschiedlichen physikalischen Eigenschaften auszubilden. Beispielsweise kann so ein einstückiger Grundkörper gebildet werden, mit einer ersten Spritzgusskomponente, die elektrisch leitende Eigenschaften und einer zweiten Spritzgusskomponente, die elektrisch leitende Eigenschaften und akustisch dämpfende Eigenschaften aufweist. Vorzugsweise weist die erste Spritzgusskomponente ein elektrisch leitendes und wärmeleitfähiges Material auf, vorzugsweise einen elektrisch leitenden und wärmeleitfähigen Kunststoff, beispielsweise Polycaprolactam. Die zweite Spritzgusskomponente weist vorzugsweise ein elektrisch leitendes und akustisch dämpfendes Material auf, beispielsweise ein thermoplastisches und elektrisch leitfähiges Elastomer. So kann ein Grundkörper individuell an ein elektronisches Gerät und ein Gehäuse angepasst werden. Es versteht sich, dass Grundkörper und Buchse einstückig ausgestaltet sein können und die Buchse beispielsweise aus einem Kunststoff gebildet sein kann, der keine elektrisch leitenden Eigenschaften aufweist. So lassen sich Materialien optimal einsetzen, was zusätzlich zu einer Kostenersparnis beiträgt.

**In** einer bevorzugten Ausführungsform der vorliegenden Erfindung gehen Grundkörper und Gehäuse eine indirekte Verbindung ein. Eine indirekte Verbindung von Grundkörper und Gehäuse liegt vor, wenn zwischen Grundkörper und Gehäuse zusätzlich ein Adapterelement eingefügt ist. Dann erfolgt die Verbindung von Grundkörper und Gehäuse über das Adapterelement. Der Grundkörper ist dann mit dem Adapterelement, und das Adapterelement mit dem Gehäuse verbunden. Das Adapterelement ist mit dem Gehäuse über ein Befestigungsmittel verbunden, beispielsweise über ein Adhäsions- und/oder Schraub- und/oder Niet- und/oder Klemm- und/oder Rastmittel. Der Grundkörper ist mit dem Adapterelement über ein Befestigungsmittel verbunden, beispielsweise über ein Adhäsions- und/oder Schraub- und/oder Niet- und/oder Klemm- und/oder Rastmittel. Es versteht sich, dass in dieser Ausführungsform eine Öffnung zum Inneren des Gehäuses im Wesentlichen durch das Adapterelement verschlossen wird. Vorzugsweise ist das Adapterelement im Wesentlichen plattenförmig oder ringförmig ausgestaltet. Vorzugsweise besteht das Adapterelement aus einem oder mehreren Kunststoffen und wird in einem Spritzgussverfahren, Mehrkomponenten-Spritzgussverfahren oder Montageverfahren hergestellt. Es versteht sich, dass Adapterelement und Grundkörper aus unterschiedlichen Werkstoffen mit unterschiedlichen physikalischen Eigenschaften hergestellt werden können. Beispielsweise kann der Grundkörper aus einem elektrisch leitenden Kunststoff und das Adapterelement aus einem elektrisch leitenden und einem elastomerischen Werkstoff mit akustisch dämpfenden Eigenschaften bestehen. Durch das Adapterelement lässt sich zudem die Verbindung von Grundkörper und Gehäuse vereinfachen. So kann eine vorkonfigurierte Lüfterbaugruppe mit einem Grundkörper, einer Buchse, einem Lüfterrotor, einem Stator, einer Lüfter Sensorik, und ggf. einer Lüfterleiterplatte mit Lüfterelektronik standardisiert werden. Zudem lässt sich der Grundkörper bei einer Ausführungsform mit Adapterelemenet, als Teil einer Lüfterbaugruppe insgesamt kleiner dimensionieren, wodurch Material eines Grundkörpers beispielsweise bei einer standardisierten Lüfterbaugruppe eingespart werden kann. Nur das Adapterelement wird dann gerätespezifisch angepasst.

In einer bevorzugten Ausführungsform der vorliegenden Erfindung besteht das Adapterelement aus einem Mehrkomponenten-Spritzguss Bauteil mit einem ersten Abschnitt und einem zweiten Abschnitt. Der erste Abschnitt weist dabei ein elektrisch leitendes und wärmeleitfähiges Material auf, vorzugsweise einen elektrisch leitenden und wärmeleitfähigen Kunststoff, beispielsweise Polycaprolactam. Der zweite Abschnitt weist ein elektrisch leitendes und akustisch dämpfendes Material auf, beispielsweise ein thermoplastisches und elektrisch leitfähiges Elastomer. Vorzugsweise sind der erste und der zweite Abschnitt plattenförmig ausgestaltet. Optional kann zumindest einer der beiden Abschnitte ringförmig ausgestaltet sein.

Bevorzugterweise weist der Grundkörper einen Aufnahmebereich auf, an dem die Buchse angeordnet ist, und der zudem bevorzugterweise so ausgestaltet ist, dass an ihm auch der Stator und ggf. eine Lüfter Sensorik angeordnet sind. Optional kann die Buchse als Halterung für den Stator ausgestaltet sein. Der Stator und ggf. die Lüfter Sensorik, beispielsweise in Form von Hallsensoren, befinden sich somit wie der Lüfterrotor ebenfalls in einem vom Inneren des Gehäuses abgetrennten Bereich. Optional kann der Aufnahmebereich auch für eine Aufnahme einer Lüfterleiterplatte ausgestaltet sein.

In einer Ausführungsform der vorliegenden Erfindung sind der Lüfter, bzw. der Lüfterrotor, der Stator und/oder die Lüfter Sensorik auf der Buchse und/oder einem Aufnahmebereich des Grundkörpers angeordnet. Es versteht sich, dass der Lüfterrotor rotierend an der Buchse gelagert ist. Bevorzugterweise ist auch eine Lüfterleiterplatte mit Lüfterelektronik auf dem Grundkörper, vorzugsweise an einem Aufnahmebereich des Grundkörpers angeordnet. In einer Ausführungsform der vorliegenden Erfindung, ist die Lüfterleiterplatte auf einer in die Kammer gerichteten Seite des Grundkörpers angeordnet. Dies macht eine Kontaktierung und Verbauung des Lüfters auf dem Grundkörper besonders einfach. In einer alternativen Ausführungsform der vorliegenden Erfindung ist die Lüfterleiterplatte auf einer Seite des Grundkörpers angeordnet, die nach dem Verbinden von Grundkörper und Gehäuse in das Innere des Gehäuses gerichtet ist. Die im Zusammenhang mit der Anordnung der Lüfterbauteile beschriebenen Ausführungsformen ermöglichen eine Vormontage der entsprechenden Lüfterbauteile auf dem Grundkörper. Zudem kann eine Standardisierung und Skalierbarkeit einer Lüfterbaugruppe erfolgen, die einen Lüfterrotor, einen Stator, eine Lüfter Sensorik, eine Buchse, einen Grundkörper und ggf. eine Lüfterleiterplatte mit Lüfterelektronik aufweist. Ferner ermöglichen diese Ausführungsformen eine vereinfachte Montage der gesamten Lüfterbaugruppe innerhalb des elektronischen Gerätes.

In einer Ausführungsform der vorliegenden Erfindung ist zumindest ein elektronisches Bauteil des Lüfters in dem Inneren des Gehäuses angeordnet. Als elektronische Bauteile des Lüfters kommen hier insbesondere elektronische Bauteile der Drehzahlsteuerung in Betracht. Das Verlegen von elektronischen Bauteilen des Lüfters in das Innere des Gehäuses bietet den Vorteil, dass der Bauraum des Lüfters selbst verringert werden kann. Insbesondere kann so die Kammer, in der der Lüfterrotor angeordnet ist, kompakter ausgestaltet werden. Zudem sind Bauteile, die im Inneren des Gehäuses angeordnet sind, zusätzlich besser vor Staub, Schmutz, feuchter Luft und/oder Flüssigkeiten geschützt. Zudem lassen sich elektronische Bauteile im Inneren des Gehäuses zusätzlich besser vor dem Eindringen von elektromagnetischer Strahlung schützen.

**In** einer bevorzugten Ausführungsform der vorliegenden Erfindung wird zumindest ein elektronisches Bauteil des Lüfters, insbesondere ein Bauteil der Lüfterelektronik auf die Geräteleiterplatte verlegt. Beispielsweise kann infolge der Integration der Steuerungselektronik des Lüfters auf die Geräteleiterplatte vorteilhaft eine Reduzierung der Polzahl der elektrischen Verbindung von Lüfter zu Geräteleiterplatte und eine Minimierung des Lüfter-Bauraums erreicht werden. In einer besonders bevorzugten Ausführungsform der vorliegenden Erfindung wird die gesamte Lüfterelektronik auf die Geräteleiterplatte verlegt. Somit kann die Lüfterleiterplatte vollständig entfallen. Durch eine Verlagerung der Lüfterelektronik in bzw. auf die Geräteleiterplatte sind nur noch drei stromführende, unempfindliche Leitungen erforderlich. Die Auswertung der Rotorposition und Drehzahl zur Ansteuerung kann zudem in einem vorhandenen Prozessor auf der Geräteleiterplatte erfolgen, was zusätzlich zu einer Kostenreduzierung beiträgt.

In einer Ausführungsform der vorliegenden Erfindung, ist der Lüfter als Axiallüfter ausgebildet. In einer bevorzugten Ausführungsform der vorliegenden Erfindung, ist der Lüfter als Diagonallüfter ausgebildet. In einer besonders bevorzugten Ausführungsform der vorliegenden Erfindung, ist der Lüfter als Radiallüfter ausgebildet. Vorzugsweise verläuft dabei die Rotationsachse des Lüfterrotors des jeweiligen Lüfters in einer Richtung senkrecht zur Erstreckungsrichtung eines Bereichs des Gehäuses mit dem der Grundkörper verbunden und an dem der Kühlkörper angeordnet ist. Dadurch, dass die Rotationsachse des Lüfterrotors des jeweiligen Lüfters senkrecht zur Erstreckungsrichtung eines Bereichs des Gehäuses verläuft mit dem der Grundkörper verbunden und an dem der Kühlkörper angeordnet ist, kann eine besonders kompakte und flache Bauweise des elektronischen Gerätes gewährleistet werden.

In einer besonders bevorzugten Ausführungsform der vorliegenden Erfindung, ist die Rotationsachse des Lüfters senkrecht zu der Geräteleiterplatte des elektronischen Gerätes angeordnet. So kann die elektrische Kontaktierung des Lüfters mit der Geräteleiterplatte vereinfacht werden, beispielsweise über eine Druckkontaktierung.

Vorzugsweise weist der Kühlkörper mindestens eine bevorzugt mehrere parallel zueinander angeordnete Kühlrippen auf. Dann sind Lüfter und Kühlkörper derart angeordnet und ausgestaltet, dass der vom Lüfterrotor erzeugte Luftstrom über die eine oder mehreren parallel zueinander angeordneten Kühlrippen streicht.

In einer Ausführungsform der vorliegenden Erfindung sind Gehäuse und Kühlkörper einstückig ausgestaltet. In einer weiteren Ausführungsform der vorliegenden Erfindung ist der Kühlkörper als separates Bauteil mit dem Gehäuse wärmeleitend verbunden. Gehäuse und Kühlkörper können aus einem Metall oder einer Metalllegierung bestehen, beispielsweise einer Aluminium- oder Magnesiumlegierung, und beispielsweise als metallische Gussteile ausgeführt sein. Beispielsweise können beide Teile in separaten Aluminiumdruckgussverfahren oder Magnesiumdruckgussverfahren einzeln, oder für eine einstückige Ausführungsform in einem gemeinsamen Aluminiumdruckgussverfahren bzw. Magnesiumdruckgussverfahren hergestellt sein. Alternativ können das Gehäuse und/oder der Kühlkörper aus einem oder mehreren Kunststoffen mit unterschiedlichen physikalischen Eigenschaften hergestellt werden. Beispielsweise können das Gehäuse und/oder der Kühlkörper in einem Spritzgussverfahren, vorzugsweise in einem Mehrkomponenten-Spritzgussverfahren hergestellt werden. Besonders bevorzugt besteht zumindest der Kühlkörper aus einem Kunststoff mit wärmeleitenden Eigenschaften. Zusätzlich kann der Kunststoff des Kühlkörpers auch elektrisch leitende Eigenschaften aufweisen.

In einer besonders bevorzugten Ausführungsform der vorliegenden Erfindung, ist die Kammer derart ausgestaltet, dass sie für den Lüfter einen Lufteinlass aus einer Richtung parallel zur Rotationsachse des Lüfterrotors und einen Luftauslass im Wesentlichen senkrecht zur Rotationsachse des Lüfterrotors ausbildet und wobei der Kühlkörper am Luftauslass angeordnet ist. Diese Art der Ausgestaltung der Kammer ermöglicht eine effiziente Luftstromführung bei einer zugleich sehr kompakten Bauweise des elektronischen Gerätes.

Das Gehäuse weist zur Ausbildung der Kammer eine um den Lüfterrotor teilweise umlaufende Mauer und eine Abdeckung auf. Die Mauer weist dabei zumindest eine Durchbrechung an einer Stelle auf, an der der Kühlkörper angeordnet ist. Die zumindest eine Durchbrechung bildet einen Luftauslass für die Luftstromführung des Lüfters. Die Abdeckung kommt auf der Mauer zum Liegen. Die Abdeckung weist eine Mehrzahl an Öffnungen auf, die einen Lufteinlass für die Luftstromführung des Lüfters bilden. Die Öffnungen in der Abdeckung können dabei jedwede beliebige Form annehmen und beispielsweise aus Schlitzen, vieleckigen Öffnungen und/oder kreisrunden Löchern bestehen. Die Ausgestaltung der Öffnungen ist dabei an keine Geometrie festgelegt und kann unter Berücksichtigung der Luftstromführung durch die Öffnungen und/oder unter akustischen Aspekten erfolgen. Es versteht sich, dass Gehäuse, Mauer und Abdeckung einstückig ausgestaltet sind. Mauer und Abdeckung sind daher einstückig miteinander verbunden. Durch die Ausgestaltung der Mauer und Abdeckung wird die Luftstromführung für den Lüfter bestimmt. Es ist ermöglicht eine Luftstromführung derart auszuführen, dass ein Lüfterrotor Luft aus einer Richtung parallel zu dessen Rotationsachse ansaugt und die angesaugte Luft über die zumindest eine Durchbrechung in der Mauer auslässt, die sich in einer Richtung im Wesentlichen senkrecht zur Rotationsachse des Lüfterrotors, also in radialer Richtung des Lüfterrotors befindet. So wird der vom Lüfterrotor erzeugte Luftstrom über den an die Durchbrechung, die den Luftauslass bildet, angrenzend angeordneten Kühlkörper geführt.

In einer weiteren besonders bevorzugten Ausführungsform der vorliegenden Erfindung weist das Gehäuse zur Ausbildung der Kammer eine Abdeckung auf, die an oder auf am Luftauslass angeordneten Kühlrippen des Kühlkörpers zum Liegen kommt. Die Abdeckung weist zudem eine Mehrzahl an Öffnungen auf, die den Lufteinlass bilden. Es versteht sich, dass in dieser Ausführungsform Kühlrippen, Kühlkörper und Abdeckung einstückige Bestandteile des Gehäuses sind. Die Kühlrippen sind einstückig mit der Abdeckung verbunden. Die Kammer wird dann im Wesentlichen von Kühlrippen, der Abdeckung und der Verbindung von Grundkörper und Gehäuse gebildet. Diese Ausführungsform trägt zu einer noch kompakteren Bauweise eines erfindungsgemäßen elektronischen Gerätes bei. Es versteht sich, dass in dieser Ausführungsform eine teilweise umlaufende Mauer nicht vorhanden sein muss. Beispielsweise können die Kühlrippen radial in alle Richtungen der Kammer angeordnet sein. Eine teilweise umlaufende Mauer kann jedoch in dieser Ausführungsform beispielsweise von Kühlrippen, die einstückiger Bestandteil des Gehäuses sind, gebildet werden.

In einer weiteren besonders bevorzugten Ausführungsform der vorliegenden Erfindung ist die Kammer zwischen Kühlrippen des Kühlkörpers angeordnet. Die Kühlrippen grenzen dabei an die Kammer an und erstrecken sich von der Kammer ausgehend in zwei sich gegenüberliegende Richtungen senkrecht zur Rotationsachse des Lüfterrotors. Der Kühlkörper ist dabei als einstückiger Bestandteil des Gehäuses ausgestaltet und die Kühlrippen sind als mehrere parallel zueinander angeordnete Kühlrippen des Kühlkörpers ausgebildet. Diese Ausführungsform besitzt den Vorteil einer großflächigen Kühlung. So können gleichzeitig mehrere elektronische Bauteile im Inneren des Gehäuses aktiv gekühlt werden, bzw. gleichzeitig mehr Wärme abtransportiert werden. Der vom Lüfter erzeugte Luftstrom kann so optimal zum Kühlen von zu mehreren Seiten der Kammer im Inneren des Gehäuses angeordneten elektronischen Bauteilen verwendet werden.

Grundsätzlich lässt sich das erfindungsgemäße elektronische Geräte überall dort verwenden, wo eine Entwärmung über eine erzwungene Konvektion mittels einer durch einen Lüfter bereitgestellte Luftströmung erfolgen soll und erhöhte Anforderungen an EMV-/ESD-, IP-Schutz auf eine einfache und kostengünstige Weise gewährleistet werden soll. Insbesondere soll die Erfindung in elektronischen Geräten in einem Fahrzeug Verwendung finden, wie etwa für leistungsstarke Computer oder Head-Up Displays, die in Fahrzeugen verbaut werden.

Weitere Merkmale der vorliegenden Erfindung werden aus der nachfolgenden Beschreibung und den angehängten Ansprüchen in Verbindung mit den Figuren ersichtlich.

### Figurenübersicht

Fig. 1 zeigt schematisch eine erste Ausführungsform eines erfindungsgemäßen elektronischen Gerätes,
Fig. 2 zeigt schematisch eine zweite Ausführungsform eines erfindungsgemäßen elektronischen Gerätes,
Fig. 3 zeigt schematisch eine dritte Ausführungsform eines erfindungsgemäßen elektronischen Gerätes, und
Fig. 4 zeigt die in Fig. 3 dargestellte dritte Ausführungsform mit leicht geänderter Sichtweise.

### Figurenbeschreibung

Zum besseren Verständnis der Prinzipien der vorliegenden Erfindung werden nachfolgend Ausführungsformen der Erfindung anhand der Figuren detaillierter erläutert. Gleiche Bezugszeichen werden in den Figuren für gleiche oder gleichwirkende Elemente verwendet und nicht notwendigerweise zu jeder Figur erneut beschrieben. Es versteht sich, dass sich die Erfindung nicht auf die dargestellten Ausführungsformen beschränkt und dass die beschriebenen Merkmale auch kombiniert oder modifiziert werden können, ohne den Schutzbereich der Erfindung zu verlassen, wie er in den angehängten Ansprüchen definiert ist.

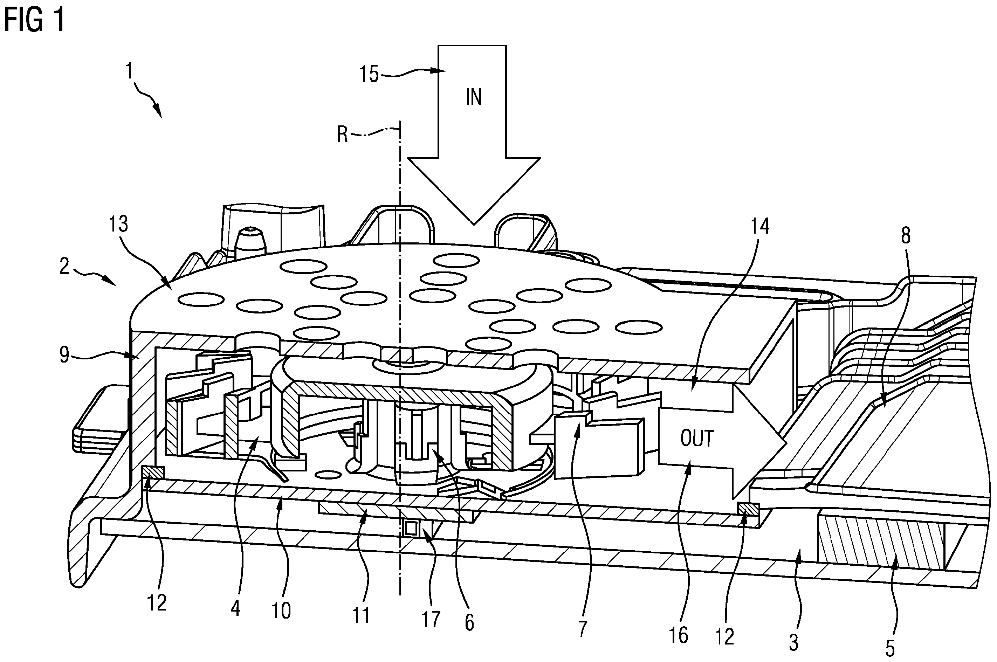

Figur 1 zeigt eine schematische Darstellung einer ersten Ausführungsform eines erfindungsgemäßen elektronischen Gerätes 1. Das elektronische Gerät 1 weist ein Gehäuse 2, eine Geräteleiterplatte 3, einen Kühlkörper 8 mit Kühlrippen und einen Lüfter 4, der als Radiallüfter ausgebildet ist, auf.

Die Geräteleiterplatte 3 ist in dem Inneren des elektronischen Gerätes 1 angeordnet und weist ein elektronisches Bauteil 5 auf, das die Funktion des elektronischen Gerätes 1 realisiert.

Der Kühlkörper 8 ist einteilig mit dem Gehäuse 2 ausgestaltet, alternativ kann der Kühlkörper 8 jedoch auch als separates Bauteil ausgestaltet und mit dem Gehäuse 2 wärmeleitend verbunden sein. Kühlkörper 8 und elektronisches Bauteil 5 sind so zueinander angeordnet, dass der Kühlkörper 8 Wärme von dem elektronischen Bauteil 5 aufnimmt. Hierzu weisen der Kühlkörper 8 und das elektronische Bauteil 5 eine thermische Kopplung auf.

Der Lüfter 4 weist einen plattenförmigen Grundkörper 10, eine Buchse 6, einen Lüfterrotor 7, einen Stator (nicht dargestellt), Hallsensoren (nicht dargestellt) und eine Lüfterleiterplatte 11, auf der Lüfterelektronik angeordnet ist, auf. Der hier verwendete Lüfter 4 ist ein PWM-Lüfter. Buchse 6 und Grundkörper 10 sind hierbei einstückig aus einem elektrisch leitenden Kunststoff in einem Spritzgussverfahren hergestellt worden. Alternativ können Buchse 6 und Grundkörper 10 auch zweistückig ausgestaltet sein und über Befestigungsmittel miteinander verbunden werden. In einer zweistückigen Ausgestaltung kann die Buchse 6 aus einem günstigeren Kunststoff ohne besondere elektrisch leitende Eigenschaften hergestellt sein. Der plattenförmige Grundkörper 10 weist eine Vertiefung auf, die als Aufnahmebereich für einen Stator (nicht dargestellt) und die Buchse 6 ausgestaltet ist. Die Buchse 6 dient zur rotierbaren Lagerung des Lüfterrotors 7, ragt einseitig aus der Vertiefung hervor und nimmt den Stator im Aufnahmebereich auf.

Grundkörper 10, Buchse 6, Lüfterrotor 7, Stator, Hallsensoren und die Lüfterleiterplatte 11, auf der Lüfterelektronik angeordnet ist bilden zusammen eine Lüfterbaugruppe. Die Lüfterbaugruppe ist bereits vorkonfiguriert, so dass bereits vor dem Einbau der einzelnen Lüfterbauteile in das elektronische Gerät 1, diese auf dem Grundkörper 10 angeordnet sind. Ein Verbinden des Grundkörpers 10 mit dem Gehäuse 2 erfolgt dabei durch einen Bereich, der das Innere des Gehäuses 2 bildet und in dem die Geräteleiterplatte 3 angeordnet wird. So wird die gesamte vorkonfigurierte Lüfterbaugruppe in dem elektronischen Gerät 1 angeordnet. Grundkörper 10 und Gehäuse 2 sind hier direkt über ein Befestigungsmittel miteinander verbunden, also ohne ein weiteres Adapterelement zwischen Grundkörper 10 und Gehäuse 2. Die Verbindung von Grundkörper 10 und Gehäuse 2 ist hierbei eine elektrisch leitende Verbindung. Das Befestigungsmittel entspricht einem elektrisch leitendem Adhäsionsmittel, hier einer vollständig umlaufenden elektrisch leitende und akustisch dämpfende Klebeverbindung 12 an einer Verbindungsstelle zwischen Grundkörper 10 und Gehäuse 2. Das Gehäuse 2 sowie der Kühlkörper 8 bestehen aus einer Aluminiumlegierung oder einer Magnesiumlegierung hergestellt in einem Druckgussverfahren. Alternativ kann das Gehäuse 2 sowie der Kühlkörper 8 aus einem wärmeleitfähigen Kunststoff bestehen und beispielsweise in einem Spritzgussverfahren bzw. Mehrkomponenten-Spritzgussverfahren hergestellt werden.

Das Gehäuse 2 des elektronischen Gerätes 1 weist eine um den Lüfterrotor 7 teilweise umlaufende Mauer 9 und eine Abdeckung 13 auf, die auf der Mauer 9 zum Liegen kommt. Mauer 9 und Abdeckung 13 sind dabei einstückig mit dem Gehäuse 2 ausgestaltet. Sie bilden zusammen mit dem Grundkörper 10 in einem verbundenen Zustand von Grundkörper 10 und Gehäuse 2 eine Kammer 14 aus, innerhalb der der Lüfterrotor 7, der Stator und die Hallsensoren angeordnet sind. Die Mauer 9 weist an einer Stelle, an der der Kühlkörper 8 angeordnet ist, eine Durchbrechung auf, die einen Luftauslass 16 bildet. Die Abdeckung 13 weist zudem eine Mehrzahl von kreisrunden Öffnungen auf, die einen Lufteinlass 15 in der Kammer 14 bilden. Im Betrieb des Lüfters 4 wird Luft über die Öffnungen in der Abdeckung 13, die den Lufteinlass 15 bilden, durch die Rotation des Lüfterrotors 7 aus einer Richtung parallel zur Rotationsachse R des Lüfterrotors 7 angesaugt. Der durch den Lüfterrotor 4 erzeugte Luftstrom wird dann über die Durchbrechung in der Mauer 9, die den Luftauslass 16 bildet, in einer Richtung im Wesentlichen senkrecht zur Rotationsachse R des Lüfterrotors 7 ausgegeben. Der Luftstrom wird so ausgegeben, dass dieser über bzw. entlang mehrerer parallel zueinander angeordnete Kühlrippen des an die Durchbrechung angrenzend angeordneten Kühlkörpers 8 streicht. Die Kammer 14, der Lüfterrotor 7 und der Kühlkörper 8 sind dabei derart ausgestaltet und zueinander angeordnet, dass eine möglichst große Fläche des Kühlkörpers 8 von dem Luftstrom überstrichen wird. Die Kammer 14 ragt in Richtung der Durchbrechung daher noch ein Stück über die Ausdehnung des Lüfterrotors 7 heraus, so dass die erzeugte Luftströmung möglichst als laminare Strömung ohne Turbulenzen über den Kühlkörper 8 bzw. die Kühlrippen streicht. Die Rotationsachse R des Lüfterrotors 4 ist senkrecht zu der Geräteleiterplatte 3 des elektronischen Gerätes 1 angeordnet und verläuft in einer Richtung senkrecht zur Erstreckungsrichtung eines Bereichs des Gehäuses 2 mit dem der Grundkörper 10 verbunden und an dem der Kühlkörper 8 angeordnet ist.

In einem verbundenen Zustand von Grundkörper 10 und Gehäuse 2 verschließt der Grundkörper 10 eine Öffnung zum Inneren des Gehäuses 2. Dadurch sind die Buchse 6, der Lüfterrotor 7, der Stator und die Hallsensoren in der Kammer 14 und in dieser in einem von dem Inneren des Gehäuses 2 abgetrennten Bereich angeordnet. Zudem bildet die Kammer 14, bzw. die Mauer 9, die Abdeckung 13 und der Grundkörper 10 ein Gehäuse für den Lüfterrotor 7 aus.

Die Lüfterleiterplatte 11, auf der sich die Lüfterelektronik, hier die Drehzahlsteuerung, befindet, ist auf einer zur Innenseite des Gehäuses 2 befindlichen Seite des Grundkörpers 10 angeordnet. Dadurch sind elektronische Bauteile des Lüfters 4 in dem Inneren des Gehäuses 2 angeordnet. Die Lüfterleiterplatte 11 und die Geräteleiterplatte 3 sind über eine Steckverbindung 17, beispielsweise eine Board to Board Steckverbindung, mechanisch und elektrisch miteinander kontaktiert. Alternativ können die Lüfterleiterplatte 11 und die Geräteleiterplatte 3 beispielsweise auch über eine Kabel- und/oder Steck-, und/oder Rast-, und/oder eine One-Piece Connector Verbindung miteinander elektrisch und/oder mechanisch verbunden sein. Optional ist zumindest eines der elektronischen Bauteile des Lüfters 4 auf die Geräteleiterplatte 3 verlegt. Optional sind sämtliche elektronischen Bauteile des Lüfters 4 auf die Geräteleiterplatte 3 verlegt, so dass die Lüfterleiterplatte 11 entfallen kann.

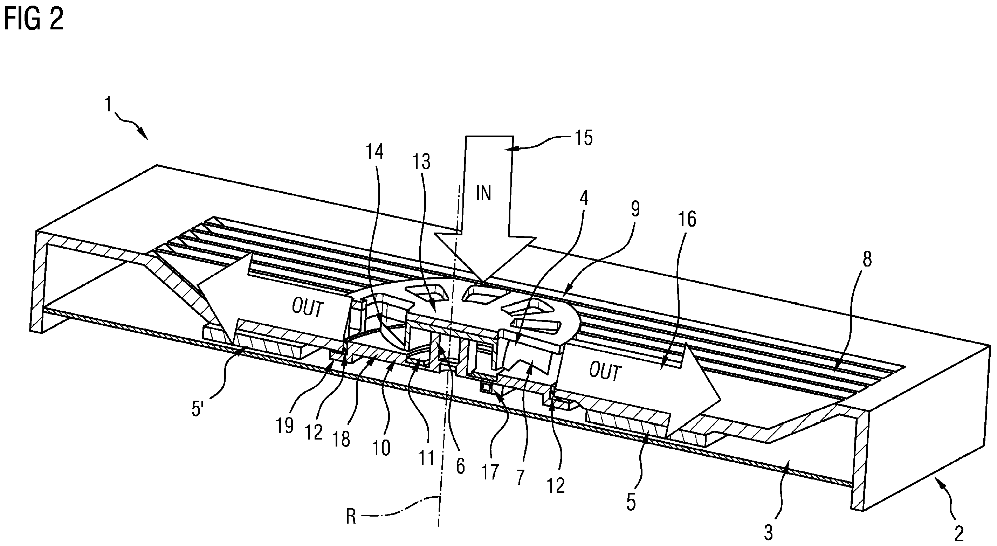

Figur 2 zeigt schematisch eine zweite Ausführungsform eines erfindungsgemäßen elektronischen Gerätes 1. Die in Figur 2 dargestellte Ausführungsform unterscheidet sich von der in Figur 1 dargestellten dadurch, dass die in Figur 2 dargestellte Kammer 14, die von dem Gehäuse 2 des elektronischen Gerätes 1 und dem Grundkörper 10 ausgebildet ist, zwischen Kühlrippen des Kühlkörpers 8 angeordnet ist. Die Kühlrippen des Kühlkörpers 8 grenzen dabei an die Kammer 14 an und erstrecken sich von der Kammer 14 ausgehend in zwei sich gegenüberliegende Richtungen senkrecht zur Rotationsachse R des Lüfterrotors 7.

Dadurch erfolgt eine Entwärmung von zu mehreren Seiten der Kammer 14 im Inneren des Gehäuses 2 auf einer Geräteleiterplatte 3 angeordneten und mit dem Kühlkörper 8 thermisch gekoppelten elektronischen Bauteilen 5, 5'. Die teilweise umlaufende Mauer 9 wird in Figur 2 von Kühlrippen des Kühlkörpers 8 gebildet, die sich entlang der Kammer 14 erstrecken. Die Abdeckung 13 der Kammer 14 kommt in Figur 2 an bzw. auf den an die Kammer 14 angrenzenden Kühlrippen des Kühlkörpers 8 zum Liegen und ist mit diesen einstückig verbunden. Die Abdeckung 13 weist in Figur 2 eine Mehrzahl an Öffnungen in Form von trapezförmigen Schlitzen auf.

Der Lüfter 4 ist in Figur 2 als Diagonallüfter ausgeführt. Alternativ kann er auch als Axiallüfter ausgeführt sein.

Ferner besteht der Grundkörper 10 aus einem Mehrkomponenten-Spritzguss Bauteil und weist zwei Spritzgusskomponenten 18, 19 auf. Die erste Spritzgusskomponente 18 ist plattenförmig ausgestaltet und weist elektrisch- und wärmeleitfähiges Material auf, beispielsweise Polycaprolactam. Die zweite Spritzgusskomponente 19 ist ringförmig ausgestaltet und weist ein elektrisch leitendes und akustisch dämpfendes Material auf, beispielsweise ein thermoplastisches und elektrisch leitfähiges Elastomer. Alternativ kann die zweite Spritzgusskomponente 19 wie die erste Spritzgusskomponente 18 plattenförmig ausgestaltet sein. An der ersten Spritzgusskomponente 18 ist die Buchse 6 angeordnet. Der Grundkörper 10 ist über die zweite Spritzgusskomponente 19 mit dem Gehäuse 2 des elektronischen Gerätes 1 direkt verbunden. Die Verbindung von Grundkörper 10 und Gehäuse 2 erfolgt über eine elektrisch leitende Klebeverbindung 12 in Form einer Klebeschicht die in einem L-förmigen Übergangsbereich der ersten Spritzgusskomponente 18 und der zweiten Spritzgusskomponente 19 angeordnet ist.

In Figur 2 ist zudem die Lüfterleiterplatte 11 in das Innere der Kammer 14 gerichtet. Die Lüfterleiterplatte 11 ist dabei zwischen Grundkörper 10 und Stator bzw. Lüfterrotor 7 angeordnet. Hierbei befinden sich sämtliche elektronischen und sensorischen Bauteile des Lüfters auf der Lüfterleiterplatte 11. Alternativ können elektronische Bauteile des Lüfters auch auf der Geräteleiterplatte 3 im Inneren des Gehäuses 2 untergebracht sein.

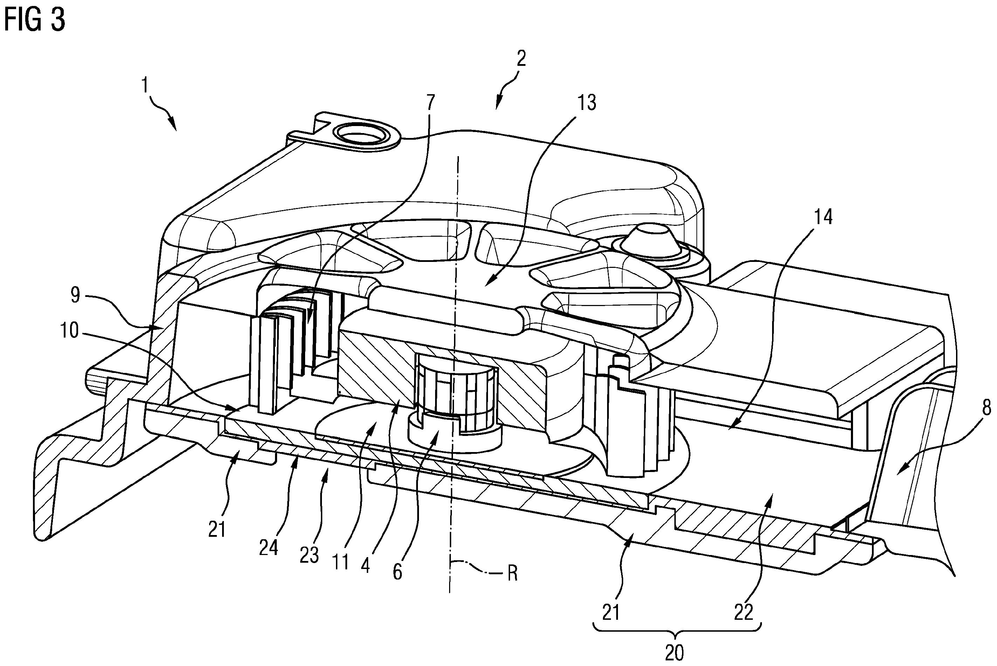

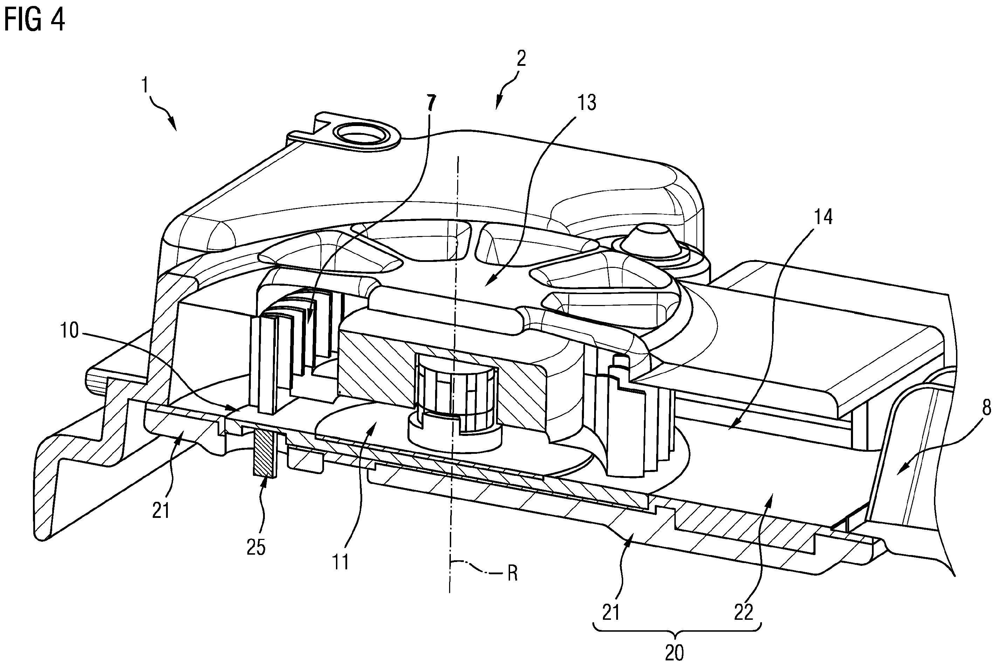

Die Figuren 3 und 4 zeigen schematisch eine dritte Ausführungsform eines erfindungsgemäßen elektronischen Gerätes 1. Figur 4 unterscheidet sich dabei von der Figur 3 durch eine leicht geänderte Sichtweise der dritten Ausführungsform. Übersichtshalber sind in den Figuren 3 und 4 Geräteleiterplatte und elektrisches Bauteil nicht dargestellt. Die in den Figuren 3 und 4 dargestellte Ausführungsform unterscheidet sich von der in Figur 1 dargestellten Ausführungsform dadurch, dass der Grundkörper 10 und das Gehäuse 2 indirekt miteinander verbunden sind. Grundkörper 10 und Gehäuse 2 sind dabei über ein plattenförmiges Adapterelement 20 miteinander verbunden. Der Grundkörper 10 ist hierbei mit dem Adapterelement 20 und das Adapterelement 20 mit dem Gehäuse 2 verbunden. In der in den Figuren 3 und 4 dargestellten Ausführungsform wird in einem verbundenen Zustand von Gehäuse 2 und Grundkörper 10 eine Öffnung zum Inneren des Gehäuses 2 durch das Adapterelement 20 verschlossen.

Das Adapterelement 20 besteht aus einem Mehrkomponenten-Spritzguss Bauteil und weist einen ersten Abschnitt 21 und einen zweiten Abschnitt 22 auf. Beide Abschnitte 21, 22 sind dabei plattenförmig ausgestaltet. Der erste Abschnitt 21 besteht aus einem elektrisch- und wärmeleitfähigen Material, hier einem elektrisch- und wärmeleitfähigen Kunststoff. Der zweite Abschnitt 22 besteht aus einem elektrisch leitenden und akustisch dämpfenden Material, hier einem thermoplastischen und elektrisch leitfähigem Elastomer. Der erste 21 und der zweite Abschnitt 22 sind schichtartig zueinander angeordnet, wobei in einem verbundenen Zustand von Grundkörper 10 und Gehäuse 2 der zweite Abschnitt 22 in Richtung der Kammer 14 und der erste Abschnitt 21 in Richtung des Inneren des Gehäuses 2 angeordnet ist. In dem verbundenen Zustand von Gehäuse 2 und Grundkörper 10 liegt das Gehäuse 2 an dem zweiten Abschnitt 22 an. Die Verbindung von Grundkörper 2 und Adapterelement 20 erfolgt hier über eine Verstemmung. Wie in der Darstellung Figur 4 gesehen werden kann, wird als Befestigungsmittel ein Verstemmpin 25 genutzt, der hier als einstückiger Bestandteil des Grundkörpers 10 ausgebildet und durch die zwei Abschnitte 22, 23 des Adapterelements 20 getrieben ist. Durch den elastomerischen Werkstoff des zweiten Abschnitts 22, erfolgt in einem Betrieb des Lüfters 4 eine akustische Entkopplung zwischen dem Gehäuse 2 und einer Lüfterbaugruppe mit einem Grundkörper 10, einer Buchse 6, einem Lüfterrotor 7, einem Stator (nicht dargestellt) und einer Lüfterleiterplatte 11. Der Verstemmpin 25 erlaubt dabei im Betrieb des Lüfters 4 eine Schwingung entlang der Erstreckung des Verstemmpins 25, die von dem elastomerischen Werkstoff des zweiten Abschnitts 22 akustisch gedämpft abgefedert wird. Eine Verbindung von Gehäuse 2 und Adapterelement 20 erfolgt hier über eine Verschraubung.

In den Figuren 3 und 4 ist die Lüfterleiterplatte 11, wie in der in Figur 2 dargestellten Ausführungsform in das Innere der Kammer 14 gerichtet. Die Lüfterleiterplatte 11 ist dabei zwischen Grundkörper 10 und Stator bzw. Lüfterrotor 7 angeordnet. Hierbei befinden sich sämtliche elektronischen und sensorischen Bauteile des Lüfters 4 auf der Lüfterleiterplatte 11. Alternativ können elektronische Bauteile des Lüfters 4 auch auf der Geräteleiterplatte 3 im Inneren des Gehäuses 2 untergebracht sein. Die elektrische Kontaktierung der Lüfterleiterplatte 11 mit der Geräteleiterplatte erfolgt hier mit einer Kabel- und Steckverbindung (nicht dargestellt). Hierbei ist das Kabel zur elektronischen Kontaktierung mit der Geräteleiterplatte auf einer in Richtung des Inneren des Gehäuses 2 gerichteten Seite der Lüfterleiterplatte 11 angeordnet. Das Kabel wird durch eine Öffnung innerhalb des Grundkörpers 10 geführt, die in Richtung der Kammer 14 von der Lüfterleiterplatte 11 verdeckt ist. Angrenzend an den Grundkörper 10 ist der zweite Abschnitt 22 des Adapterelements 20 angeordnet. Der zweite Abschnitt 22 weist zur Kabeldurchführung eine geschlitzte Durchführung 24 auf, die sich aufgrund des verwendeten elastomerischen Werkstoffs an das durchgeführte Kabel anschmiegt und eine Öffnung in dem zweiten Abschnitt 22 weitestgehend verschließt. Zur Durchführung des Kabels durch den ersten Abschnitt 21, weist dieser angrenzend an die Durchführung 24 im zweiten Abschnitt 22 einen geöffneten Bereich 23 auf. Dies kann insbesondere der Figur 3 entnommen werden.

Durch die Ausgestaltung des Adapterelements 20 mit einem ersten Abschnitt 21 und einem zweiten Abschnitt 22 können der Grundkörper 10 und die Buchse 6 als einstückiges Spritzgussbauteil gebildet und aus einem günstigeren Werkstoff hergestellt werden, beispielsweise aus einem Kunststoff ohne besondere elektrisch leitende Eigenschaften.

Ein weiterer Unterschied zu der in Figur 1 dargestellten Ausführungsform besteht darin, dass die Abdeckung 13 in der in den Figuren 3 und 4 dargestellten Ausführungsform eine Mehrzahl an Öffnungen in Form von trapezförmigen Schlitzen aufweist.

### Bezugszeichenliste

- 1: Elektronisches Gerät
- 2: Gehäuse
- 3: Geräteleiterplatte
- 4: Lüfter
- 5, 5': elektronisches Bauteil
- 6: Buchse
- 7: Lüfterrotor
- 8: Kühlkörper
- 9: Mauer
- 10: Grundkörper
- 11: Lüfterleiterplatte
- 12: elektrisch leitende Klebeverbindung
- 13: Abdeckung
- 14: Kammer
- 15: Lufteinlass
- 16: Luftauslass
- 17: Steckverbindung
- 18: erste Spritzgusskomponente
- 19: zweite Spritzgusskomponente
- 20: Adapterelement
- 21: erster Abschnitt
- 22: zweiter Abschnitt
- 23: geöffneter Bereich
- 24: Durchführung
- 25: Verstemmpin
- R: Rotationsachse des Lüfters

## Patentansprüche

1. Elektronisches Gerät (1) mit einem Gehäuse (2), mindestens einer Geräteleiterplatte (3), einem Kühlkörper (8) und einem Lüfter (4) mit einem Lüfterrotor (7),
wobei die mindestens eine Geräteleiterplatte (3) in dem Inneren des Gehäuses (2) angeordnet ist und zumindest ein elektronisches Bauteil (5, 5') aufweist und wobei das zumindest eine elektronische Bauteil (5, 5') die Funktion des elektronischen Gerätes (1) realisiert,
wobei der Kühlkörper (8) Wärme von dem zumindest einen elektronischen Bauteil (5, 5') aufnimmt und durch einen von dem Lüfterrotor (7) erzeugten Luftstrom, der über den Kühlkörper (8) streicht, abgekühlt wird,
wobei das Gehäuse (2) mit einem Grundkörper (10) des Lüfters (4) verbunden ist,
wobei der Grundkörper (10) mit einer Buchse (6) verbunden ist, auf der der Lüfterrotor (7) rotierend gelagert ist,
wobei durch das Gehäuse (2) eine Kammer (14) ausgebildet wird, in der der Lüfterrotor (7) angeordnet ist, wobei die Kammer (14) ein Gehäuse für den Lüfterrotor (7) ausbildet,
wobei das Gehäuse (2) des elektronischen Gerätes (1) zur Ausbildung der Kammer (14) eine um den Lüfterrotor (7) teilweise umlaufende Mauer (9) und eine Abdeckung (13) aufweist, wobei die Mauer zumindest eine Durchbrechung an einer Stelle aufweist, an der der Kühlkörper (8) angeordnet ist,
wobei die Abdeckung (13) auf der Mauer (9) zum Liegen kommt und eine Mehrzahl an Öffnungen aufweist, die einen Lufteinlass für den Lüfter (4) bilden,
**dadurch gekennzeichnet, dass**
in einem verbundenen Zustand des Grundkörpers (10) mit dem Gehäuse (2) des elektronischen Gerätes (1) eine Öffnung zum Inneren des Gehäuses (2) des elektronischen Gerätes (1) verschlossen ist, und dass in diesem verbundenen Zustand die Kammer (14) von dem Inneren des Gehäuses (2) des elektronischen Gerätes (1) getrennt ist.

2. Elektronisches Gerät (1) nach Anspruch 1, **dadurch gekennzeichnet, dass** der Lüfter (4) als Axiallüfter, bevorzugt als Diagonallüfter und besonders bevorzugt als Radiallüfter ausgebildet ist, wobei die Rotationsachse (R) des Lüfterrotors (7) des jeweiligen Lüfters (4) in einer Richtung senkrecht zur Erstreckungsrichtung eines Bereichs des Gehäuses (2) des elektronischen Gerätes (1) verläuft mit dem der Grundkörper (10) verbunden und an dem der Kühlkörper (8) angeordnet ist.

3. Elektronisches Gerät (1) nach einem der Ansprüche 1 oder 2, **dadurch gekennzeichnet, dass** die Kammer (14) derart ausgestaltet ist, dass sie für den Lüfter (4) einen Lufteinlass (15) aus einer Richtung parallel zur Rotationsachse (R) des Lüfterrotors (7) und einen Luftauslass (16) im Wesentlichen senkrecht zur Rotationsachse (R) des Lüfterrotors (7) ausbildet und wobei der Kühlkörper (8) am Luftauslass (16) angeordnet ist.

4. Elektronisches Gerät (1) nach einem der vorhergehenden Ansprüche, **dadurch gekennzeichnet, dass** die Abdeckung (13) an oder auf am Luftauslass (16) angeordneten Kühlrippen des Kühlkörpers (8) zum Liegen kommt.

5. Elektronisches Gerät (1) nach einem der vorhergehenden Ansprüche, **dadurch gekennzeichnet, dass** die Kammer (14) zwischen Kühlrippen des Kühlkörpers (8) angeordnet ist, die an die Kammer (14) angrenzen und sich ausgehend von der Kammer (14) in zwei gegenüberliegende Richtungen senkrecht zur Rotationsachse (R) des Lüfterrotors (7) erstrecken.

6. Elektronisches Gerät (1) nach einem der vorhergehenden Ansprüche, **dadurch gekennzeichnet, dass** der Grundkörper (10) aus einem elektrisch leitenden Material besteht.

7. Elektronisches Gerät (1) nach einem der vorhergehenden Ansprüche, **dadurch gekennzeichnet, dass** der Grundkörper (10) und das Gehäuse (2) des elektronischen Gerätes (1) eine elektrisch leitende Verbindung, vorzugsweise eine elektrisch leitende Klebeverbindung und besonders bevorzugt eine elektrisch leitende und akustisch dämpfende Klebeverbindung (12), aufweisen.

8. Elektronisches Gerät (1) nach einem der Ansprüche 1 bis 6, **dadurch gekennzeichnet, dass** der Grundkörper (10) und das Gehäuse (2) des elektronischen Gerätes (1) über ein Adapterelement (20) miteinander verbunden sind.

9. Elektronisches Gerät (1) nach Anspruch 8, **dadurch gekennzeichnet, dass** das Adapterelement (20) aus einem Mehrkomponenten-Spritzguss Bauteil besteht, mit einem ersten Abschnitt (21), der ein elektrisch- und wärmeleitfähiges Material aufweist und einem zweiten Abschnitt (22), der ein elektrisch leitfähiges und akustisch dämpfendes Material aufweist.

10. Elektronisches Gerät (1) nach einem der vorhergehenden Ansprüche, **dadurch gekennzeichnet, dass** zumindest ein elektronisches Bauteil des Lüfters (4) in dem Inneren des Gehäuses (2) des elektronischen Gerätes (1) angeordnet ist.

11. Elektronisches Gerät (1) nach einem der vorhergehenden Ansprüche, **dadurch gekennzeichnet, dass** zumindest ein elektronisches Bauteil des Lüfters (4) auf die Geräteleiterplatte (3) verlegt wird.

## Claims

1. An electronic device (1) having a housing (2), having at least one device circuit board (3), having a heat sink (8) and having a fan (4) with a fan rotor (7),
wherein the at least one device circuit board (3) is arranged in the interior of the housing (2) and has at least one electronic component (5, 5'), and wherein the at least one electronic component (5, 5') implements the function of the electronic device (1),
wherein the heat sink (8) absorbs heat from the at least one electronic component (5, 5') and is cooled by an air stream which is generated by the fan rotor (7) and which flows over the heat sink (8),
wherein the housing (2) is connected to a main body (10) of the fan (4), wherein the main body (10) is connected to a bushing (6) on which the fan rotor (7) is mounted for rotation,
wherein the housing (2) forms a chamber (14) in which the fan rotor (7) is arranged,
wherein the chamber (14) forms a housing for the fan rotor (7),
wherein, to form the chamber (14), the housing (2) of the electronic device (1) has a wall (9), which partially encircles the fan rotor (7), and a cover (13), wherein the wall has at least one aperture at a location at which the heat sink (8) is arranged,
wherein the cover (13) comes to lie on the wall (9) and has a multiplicity of openings that form an air inlet for the fan (4),
**characterised in that**, in a connected state of the main body (10) to the housing (2) of the electronic device (1), an opening to the interior of the housing (2) of the electronic device (1) is closed off, and **in that** in this connected state, the chamber (14) is separated from the interior of the housing (2) of the electronic device (1).

2. The electronic device (1) as claimed in claim 1, **characterised in that** the fan (4) is configured as an axial fan, preferably as a diagonal fan and particularly preferably as a radial fan, wherein the axis of rotation (R) of the fan rotor (7) of the respective fan (4) runs in a direction perpendicular to the direction of extent of a region, to which the main body (10) is connected and on which the heat sink (8) is arranged, of the housing (2) of the electronic device (1).

3. The electronic device (1) as claimed in either one of claims 1 and 2, **characterised in that** the chamber (14) is designed so as to form, for the fan (4), an air inlet (15) from a direction parallel to the axis of rotation (R) of the fan rotor (7) and an air outlet (16) substantially perpendicular to the axis of rotation (R) of the fan rotor (7), and wherein the heat sink (8) is arranged at the air outlet (16).

4. The electronic device (1) as claimed in any one of the preceding claims,
**characterised in that** the cover (13) comes to lie at or on cooling fins, which are arranged at the air outlet (16), of the heat sink (8).

5. The electronic device (1) as claimed in any one of the preceding claims,
**characterised in that** the chamber (14) is arranged between cooling fins of the heat sink (8), which cooling fins adjoin the chamber (14) and extend from the chamber (14) in two opposite directions perpendicular to the axis of rotation (R) of the fan rotor (7).

6. The electronic device (1) as claimed in any one of the preceding claims,
**characterised in that** the main body (10) is composed of an electrically conductive material.

7. The electronic device (1) as claimed in any one of the preceding claims,
**characterised in that** the main body (10) and the housing (2) of the electronic device (1) have an electrically conductive connection, preferably an electrically conductive adhesive connection, and particularly preferably an electrically conductive and acoustically damping adhesive connection (12).

8. The electronic device (1) as claimed in any one of claims 1 to 6, **characterised in that** the main body (10) and the housing (2) of the electronic device (1) are connected to one another by means of an adapter element (20).

9. The electronic device (1) as claimed in claim 8, **characterised in that** the adapter element (20) is composed of a multi-constituent injection-moulded component, having a first portion (21), which has an electrically and thermally conductive material, and a second portion (22), which has an electrically conductive and acoustically damping material.

10. The electronic device (1) as claimed in any one of the preceding claims,
**characterised in that** at least one electronic component of the fan (4) is arranged in the interior of the housing (2) of the electronic device (1).

11. The electronic device (1) as claimed in any one of the preceding claims,
**characterised in that** at least one electronic component of the fan (4) is located on the device circuit board (3).

## Revendications

1. Dispositif électronique (1) comprenant un boîtier (2), au moins une carte de circuit imprimé du dispositif (3), un dissipateur thermique (8) et un ventilateur (4) avec un rotor de ventilateur (7),
dans lequel l'au moins une carte de circuit imprimé du dispositif (3) est disposée à l'intérieur du boîtier (2) et présente au moins un composant électronique (5, 5') et dans lequel l'au moins un composant électronique (5, 5') met en œuvre la fonction du dispositif électronique (1),
dans lequel le dissipateur thermique (8) absorbe la chaleur de l'au moins un composant électronique (5, 5') et est refroidi par un flux d'air généré par le rotor de ventilateur (7) qui passe sur le dissipateur thermique (8),
dans lequel le boîtier (2) est relié à un corps de base (10) du ventilateur (4), dans lequel le corps de base (10) est relié à un support (6) sur lequel le rotor de ventilateur (7) est monté de manière rotative,
dans lequel le boîtier (2) forme une chambre (14) dans laquelle est disposé le rotor de ventilateur (7), dans lequel la chambre (14) forme un boîtier pour le rotor de ventilateur (7),
dans lequel le boîtier (2) du dispositif électronique (1) présente une paroi (9) entourant partiellement le rotor de ventilateur (7) et un couvercle (13) pour la formation de la chambre (14), dans lequel la paroi présente au moins une ouverture à un endroit où est disposé le dissipateur thermique (8),
dans lequel le couvercle (13) repose sur le mur (9) et présente une pluralité d'ouvertures qui forment une entrée d'air pour le ventilateur (4),
**caractérisé en ce que**, dans un état connecté du corps de base (10) avec le boîtier (2) du dispositif électronique (1), une ouverture vers l'intérieur du boîtier (2) du dispositif électronique (1) est fermée, et que, dans cet état connecté, la chambre (14) est séparée de l'intérieur du boîtier (2) du dispositif électronique (1).

2. Dispositif électronique (1) selon la revendication 1, **caractérisé en ce que** le ventilateur (4) est conçu comme un ventilateur axial, de préférence comme un ventilateur diagonal et de manière particulièrement préférée comme un ventilateur radial, dans lequel l'axe de rotation (R) du rotor de ventilateur (7) du ventilateur (4) respectif tourne dans une direction perpendiculaire à la direction d'extension d'une région du boîtier (2) du dispositif électronique (1) à laquelle le corps de base (10) est relié et sur laquelle le dissipateur thermique (8) est disposé.

3. Dispositif électronique (1) selon l'une quelconque des revendications 1 ou 2,
**caractérisé en ce que** la chambre (14) est conçue de manière à former une entrée d'air (15) pour le ventilateur (4) dans une direction parallèle à l'axe de rotation (R) du rotor de ventilateur (7) et une sortie d'air (16) essentiellement perpendiculaire à l'axe de rotation (R) du rotor de ventilateur (7), et dans lequel le dissipateur thermique (8) est disposé au niveau de la sortie d'air (16).

4. Dispositif électronique (1) selon l'une quelconque des revendications précédentes, **caractérisé en ce que** le couvercle (13) vient reposer sur ou contre les ailettes de refroidissement du dissipateur thermique (8) disposées au niveau de la sortie d'air (16).

5. Dispositif électronique (1) selon l'une quelconque des revendications précédentes, **caractérisé en ce que** la chambre (14) est disposée entre les ailettes de refroidissement du dissipateur thermique (8) qui jouxtent la chambre (14) et s'étendent à partir de la chambre (14) dans deux directions opposées perpendiculaires à l'axe de rotation (R) du rotor de ventilateur (7).

6. Dispositif électronique (1) selon l'une quelconque des revendications précédentes, **caractérisé en ce que** le corps de base (10) est constitué d'un matériau électriquement conducteur.

7. Dispositif électronique (1) selon l'une quelconque des revendications précédentes, **caractérisé en ce que** le corps de base (10) et le boîtier (2) du dispositif électronique (1) présentent une connexion électriquement conductrice, de préférence une connexion adhésive électriquement conductrice et de manière particulièrement préférée une connexion adhésive électriquement conductrice et à amortissement acoustique (12).

8. Dispositif électronique (1) selon l'une quelconque des revendications 1 à 6,
**caractérisé en ce que** le corps de base (10) et le boîtier (2) du dispositif électronique (1) sont reliés entre eux par un élément adaptateur (20).

9. Dispositif électronique (1) selon la revendication 8, **caractérisé en ce que** l'élément adaptateur (20) est constitué d'une pièce moulée par injection à plusieurs composants, comprenant une première section (21) qui présente un matériau électriquement et thermiquement conducteur et une seconde section (22) qui présente un matériau électriquement conducteur et à amortissement acoustique.

10. Dispositif électronique (1) selon l'une quelconque des revendications précédentes, **caractérisé en ce qu'**au moins un composant électronique du ventilateur (4) est disposé à l'intérieur du boîtier (2) du dispositif électronique (1).

11. Dispositif électronique (1) selon l'une quelconque des revendications précédentes, **caractérisé en ce qu'**au moins un composant électronique du ventilateur (4) est placé sur la carte de circuit imprimé du dispositif (3).
